# EUROPÄISCHE PATENTSCHRIFT

(11) **EP 0 787 305 B1**
(45) Veröffentlichungstag und Bekanntmachung des Hinweises auf die Patenterteilung: **13.05.1998**
(21) Anmeldenummer: 95935806.0
(22) Anmeldetag: 25.10.1995
(51) Int. Cl.: G01R 31/327

(54) **SCHALTGERÄT MIT ÜBERWACHUNG DES ABBRANDES WENIGSTENS EINES KONTAKTSTÜCKES**
SWITCHING DEVICE WITH MONITORING THE WEAR OF AT LEAST ONE CONTACT
DISPOSITIF DE COMMUTATION AVEC CONTROLE DE L'USURE D'AU MOINS UNE PIECE DE CONTACT DE COMMUTATION

(30) Priorität: 27.10.1994 DE 4438475
(43) Veröffentlichungstag der Anmeldung: 06.08.1997
(73) Patentinhaber: SIEMENS AKTIENGESELLSCHAFT, 80333 München (DE)
(72) Erfinder: KIESER, Jörg, D-91301 Forchheim (DE); BRANSTON, David-Walter, D-91090 Effeltrich (DE); MAIER, Reinhard, D-91074 Herzogenaurach (DE); VOSS, Erich, D-92224 Amberg (DE)
(86) Internationale Anmeldenummer: DE9501483
(87) Internationale Veröffentlichungsnummer: WO9613732

(56) Entgegenhaltungen:
- DE-A- 3 714 802
- DE-A- 4 028 721

## Beschreibung

Die Erfindung bezieht sich auf ein Schaltgerät, insbesondere Schutz oder Leistungsschalter, mit Kontaktstücken, die in einem Schaltgerätegehäuse auf Kontaktträgern befestigt sind, und mit einer elektrisch isolierten Signalleitung als Mittel zum Überwachen des Kontaktabbrandes, wobei eine Beschädigung bzw. Zerstörung der Signalleitung zur Erzeugung eines externen Signals als Indiz für das Lebensdauerende wenigstens eines der Kontaktstücke herangezogen wird.

Die Lebensdauer von Schaltkontaktstücken wird durch den Abbrand, d.h. den allmählichen Verlust des Kontaktmaterials unter dem Einfluß des beim Schaltvorgang entstehenden Lichtbogens bestimmt. Der Abbrand wird dabei die Kontaktstücke in der Regel ungleichmäßig abtragen. Das Lebensdauerende ist erreicht, wenn im Kontaktbereich an mindestens einer Stelle das Kontaktmaterial entweder völlig wegerodiert oder auf eine definierte Mindestdicke abgetragen ist.

Bisher ist in der Praxis der Zustand der Schaltkontaktstücke nur durch Öffnen des Schaltgerätes und visuelle Inspektion beurteilbar. Dies gilt insbesondere für die noch zu erwartende Restlebensdauer, deren Kenntnis von zentraler Bedeutung für die Funktiontüchtigkeit des Schaltgerätes und damit für die Betriebssicherheit des geschalteten Verbrauchers ist.

Aus der DE-OS 40 28 721 ist ein Verfahren zur Ermittlung der Restlebensdauer von Schaltgeräten bekannt, bei dem die während eines Schaltvorganges geflossene Ladung elektronisch ermittelt und für die Schaltvorgänge aufsummiert werden. Dieses Verfahren ist im Prinzip her nicht nur geeignet, eine definierte Restlebensdauer anzuzeigen, sondern darüber hinausgehend auch den Abbrandzustand der Kontaktstücke zu jedem beliebigen Zeitpunkt anzugeben. Allerdings ist ein vergleichsweise hoher Aufwand für die diesbezügliche Elektronik erforderlich, so daß eine Wirtschaftlichkeit nur bei großen Schaltgeräten gegeben sein dürfte.

Mit der älteren, nicht vorveröffentlichten internationalen Patentanmeldung PCT/DE 94/00244 ist weiterhin ein Schaltgerät bekannt, bei dem die Kontaktstücke rückseitig geschlitzt und auf einem geteilten Kontaktträger aufgebracht sind. Durch diese Anordnung kann die Restlebensdauer des Kontaktes bestimmt werden: Wenn der Abbrand das über dem Schlitz befindliche Material wegerodiert hat, entstehen zwei Kontakthälften. Beim Schalten in diesem Zustand tritt zwischen den beiden Kontakthälften ein Potentialunterschied auf, der als Spannung gemessen und zur Anzeige für den Kontaktabbrand verwendet werden kann. Schließlich ist aus der DE-OS 37 14 802 ein elektronischer Schalter bekannt, bei dem wenigstens einem der Kontaktstücke ein Lichtleiter zugeordnet ist, dessen Transmissionseigenschaften von außen mittels geeigneter optischer Hilfseinrichtungen gemessen werden können. Dabei soll ein unzulässig fortgeschrittener Kontaktabbrand zur Änderung der optischen Transmissionseigenschaften und schließlich zur Zerstörung des Lichtleiters führen. Im einzelnen ist vorgesehen, daß jedes der Kontaktstücke mit einem solchen Lichtleiter komplettiert werden muß.

Davon ausgehend ist es Aufgabe der Erfindung, ein Schaltgerät zu schaffen, bei dem die Ermittlung und Anzeige einer definierten Restlebensdauer während des Betriebes des Schaltgerätes absolut zuverlässig gemeinsam für alle Kontaktanordnungen gewährleistet ist. Dabei soll eine wirtschaftliche Realisierung auch für kleinere Schaltgeräte gegeben werden.

Die Aufgabe ist erfindungsgemäß dadurch gelöst, daß zwischen den Kontaktstücken und den zugehörigen Kontaktträgern oder im Kontaktmaterial selbst die elektrische Signalleitung U-förmig geführt ist.

Die isolierte Signalleitung ist entweder aus doppelt geführten Drähten oder einer U-förmigen Schleife mit zwei isolierten Zuleitungen gebildet. Dabei können die U-förmigen Schleifen eines Meßdrahtes vorzugsweise in einer metallummantelten Röhre gegeneinander isoliert geführt sein. Beispielsweise sind solche Leitungen als erdfreie Mantelthermoelemente vorbekannt und können insofern erfindungsgemäß für den vorliegenden Zweck verwendet werden.

Bei der Erfindung kann das Kontaktstück an seiner rückseitigen Lotfläche eine Nut, ein Sackloch oder anderweitige Bohrungen aufweisen, in welche die isolierte Signalleitung eingefügt werden kann. Insbesondere kann die Isolation aus einer Glasfaserummantelung oder aus einer anderen temperaturbeständigen Isolation bestehen.

Mit der Erfindung ist eine Anordnung geschaffen, die bei allen betriebszuständen eine optimale Funktionssicherheit gewährleistet. Insbesondere mehrpolige Schaltgeräte können damit in geeigneter Weise auf den Abbrand überwacht werden, wobei üblicherweise bei Verschleiß eines Kontaktstückes eine Anzeige erfolgt, die nicht auf ein bestimmtes Kontaktstück lokalisiert zu sein braucht.

Weitere Einzelheiten und Vorteile der Erfindung ergeben sich aus der nachfolgenden Figurenbeschreibung von Ausführungsbeispielen anhand der Zeichnung. Es zeigen jeweils in grobschematischer Darstellung
- Figur 1: eine dreipolige Schützkontaktanordnung mit in einem einzigen Schaltkreis angeordneten Überwachungsmitteln sowie
- Figur 2 bis 5: unterschiedliche Ausführungsformen von konkreten Überwachungskreisen.

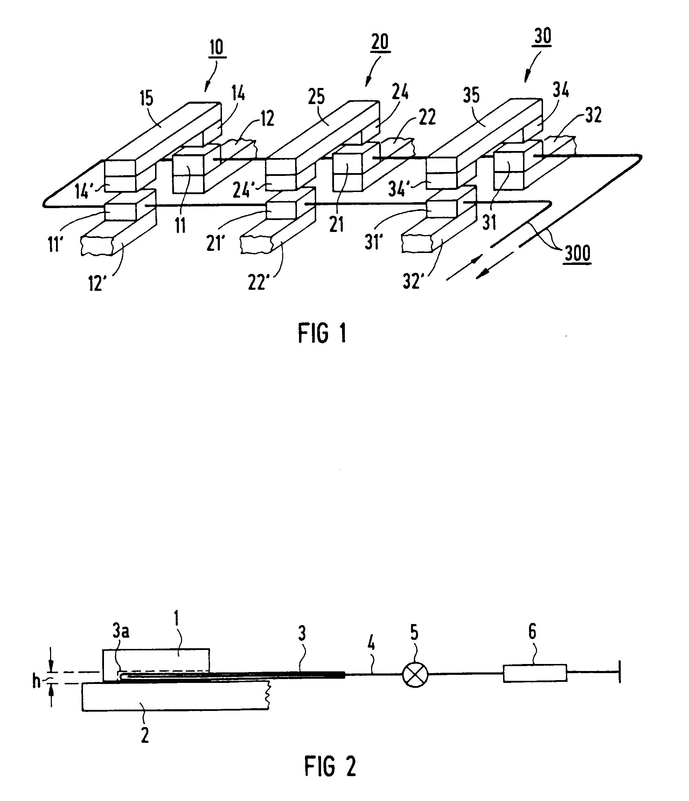

In Figur 1 ist eine Kontaktanordnung für ein dreipoliges Schütz vereinfacht dargestellt, bei dem jeweils Kontaktanordnungen 10, 20 und 30, die aus je zwei Festkontaktstücken 11, 21, 31 bzw. 11', 21', 31' bestehen, welche auf Kontaktträger 12, 22 und 32 bzw. 12', 22' und 32' aufgelötet sind. Auf die Gegenkontakte 14, 24, 34 bzw. 14', 24', 34', die je an einer beweglichen Kontaktbrücke 15, 25 und 35 angelötet sind, wird in diesem Zusammenhang nicht im einzelnen eingegangen. Prinzipiell könnten die nachfolgend beschriebenen Meßmittel auch an den Bewegkontakten angebracht sein.

In Figur 1 ist eine einzige isolierte Signalleitung 300 vorhanden, welche durch die einzelnen Kontakte hindurchläuft und einen geschlossenen Signalleiterkreis bildet. Dafür können in den einzelnen Kontakten 11, 21, 31 bzw. 11', 21', 31' Durchbohrungen vorhanden sein. Es ist auch möglich, die Signalleitung 300 zwischen den Einzelkontakten und den Kontaktträgern zu führen. Gegebenenfalls können in den Kontakten Einfräsungen bzw. Nuten vorhanden sein.

In Figur 2 ist ein Kontaktstück 1, das auf einem Kontaktträger 2 aufgelötet ist, mit einer Nut 3a versehen, in der eine isolierte Signalleitung liegt, die aus einer Isolation 3 und einem metallischen Leiter 4 besteht. Über eine Anzeige 5 und einen Vorwiderstand 6 ist der Leiter 4 mit dem Nulleiter oder einer weiteren Phase des Schaltnetzes verbunden.

Die Isolation 3 kann bei Figur 2 insbesondere aus einer Glasfaserummantelung bestehen. Wird ein solcher Abbrandzustand des Kontaktstückes 1 erreicht, daß die Nut 3a und damit die Isolation 3 dem Schaltlichtbogen ausgesetzt ist, so wird sie zerstört und der Leiter 4 erhält das elektrische Potential des Kontaktstückes 1. Über den Widerstand 6 erfolgt ein begrenzter Stromfluß, welcher die Anzeige 5, beispielsweise eine Leuchtdiode (LED), direkt aktiviert.

In Figur 2 definiert also die Höhe h der Nut direkt den Abbrandzustand, für den beispielsweise eine Anzeige "Restlebensdauer noch x-%" aktiviert werden kann.

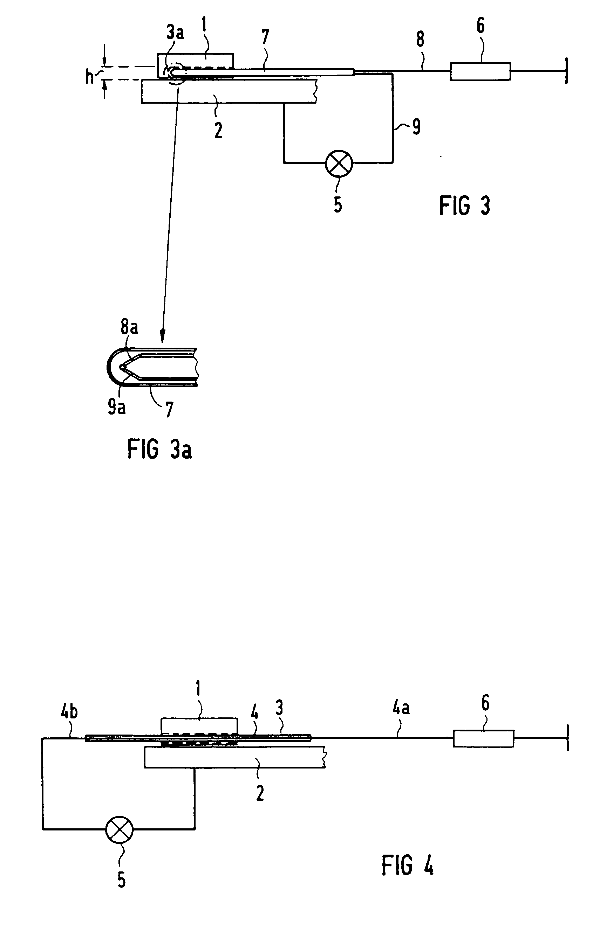

In Figur 3 ist eine U-förmige Schleife eines isolierten Drahtes in die Nut 3a gelegt: Diese Anordnung kann aus einer metallummantelten Röhre 7 mit zwei darin untereinander isoliert und auch vom Mantel isoliert angebrachten Drähten 8 und 9 bestehen. Letztere Anordnung wird beispielsweise durch ein erdfreies Mantelthermoelement realisiert. Bei solchen Mantelthermoelementen beträgt der Außendurchmesser des Mantels 7 typischerweise 1 mm. In der Vergrößerung gemäß Figur 3a ist eine Aufsicht dargestellt, wobei die Leiterenden der U-förmigen Schleife mit 8a und 8b bezeichnet sind.

Beim Beispiel gemäß Figur 3 fließt von der Kontaktbrücke ein Strom 2 ständig durch die Anzeige 5, die beiden Leiter 8, 9 des Mantelthermoelementes und über den begrenzenden Widerstand zum Nulleiter oder eine andere Phase im Schaltgerät. In diesem Fall bedeutet die Aktivierung der Anzeige 5, beispielsweise einer Leuchtdiode (LED), daß die Restlebensdauer noch nicht erreicht ist.

Bei Zerstörung des Mantelelementes durch Erosion erlöscht die Anzeige 5, sobald der Leiter 9 entweder vom Leiter 8 getrennt wird und/oder mit dem Mantel 7 Kontakt bekommt.

In der Figur 4 ist eine Festkontaktbrücke 2 mit einem Kontaktstück 1 dargestellt, auf dessen Rückseite ein metallischer Leiter 4 in einer Isolierung 3 hindurchläuft und Anschlußenden 4a und 4b hat. Von der Kontaktbrücke 2 fließt ein Strom über die Anzeige 5, den metallischen Leiter 4 und den Vorwiderstand an Null oder eine andere Phase, solange die Isolation 3 intakt ist. In diesem Fall wird angezeigt, daß die Restlebensdauer noch nicht erreicht ist. Sobald der Schaltlichtbogen die Isolation 3 und den Leiter 4 zerstört hat, wird der Stromfluß zur Anzeige unterbrochen. Dies gilt sowohl für den Fall der einfachen Unterbrechung des Leiters 4 als auch in dem Fall, daß der Leiter 4 zusätzlich Kontakt mit dem Kontaktstück 1 bekommt und damit die Anzeige 5 kurzgeschlossen wird.

Vorteilhaft ist bei den beschriebenen Ausführungsbeispielen, daß der kostenmäßige Aufwand vergleichsweise gering ist und allein durch die Applikation der Signalleitung im Schaltkontakt bestimmt wird. Dabei kann beispielsweise durch Anschaltung eines Anzeigemittels an den Kontaktträger das Potential zur Anzeige herangezogen werden. In jedem Fall wird der Zustand, daß die Restlebensdauer des Schaltgerätes erreicht ist, erkannt und signalisiert.

Die anhand der Ausführungsbeispiele 2 bis 4 beschriebenen Anordnungen können für mehrphasige Schütze entsprechend dem Schema der Figur 1 ausgelegt werden. Besonders vorteilhaft ist dabei, daß nur eine einzige Signalleitung notwendig ist.

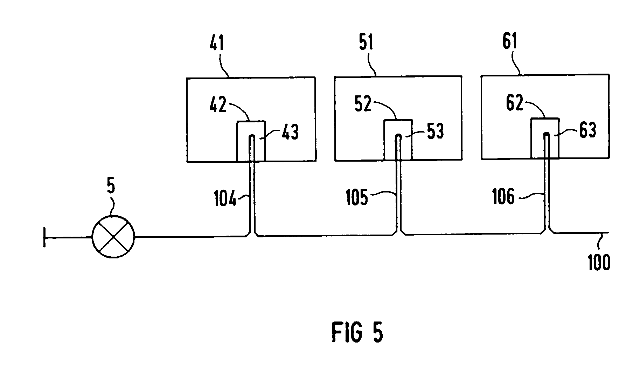

In Figur 5 ist eine Anordnung mit drei Kontaktstücken 41, 51 und 61 gezeigt, die jeweils rückseitig ein Sackloch 42, 52 und 62 aufweisen. In die Sacklöcher 42, 52 und 62 sind über entsprechende Isolationen 43, 53 und 63 Signalleitungen eingebracht. Beispielsweise kann entsprechend Figur 5 ein einziger Meßdraht 100 vom Anzeigegerät 5 so geführt sein, daß der jeweilige Abzweig 104, 105 und 106 für die Kontaktstücke 41, 51 und 62 doppelt bzw. U-förmig ensprechend dem Mantelthermoelement gemäß Figur 3a geführt ist.

Durch die Doppeldrahtausführung ist die Sicherheit der Anzeige bei auch nur partieller Zerstörung gewährleistet. Zusätzlich ist die parallele Überwachung möglich. Damit können viele Kontakte durch eine einzige Anordnung gleichzeitig und kostengünstig überwacht werden.

## Patentansprüche

1. Schaltgerät, insbesondere Schutz oder Leistungsschalter, mit Kontaktstücken (1; 11, 21, 31; 41, 51, 61), die in einem Schaltgerätegehäuse auf Kontaktträgern (2; 12, 22, 32) befestigt sind, und mit einer elektrisch isolierten Signalleitung (4, 100, 300) als Mittel zum Überwachen des Kontaktabbrandes, wobei eine Beschädigung bzw. Zerstörung der Signalleitung (4, 100, 300) zur Erzeugung eines externen Signals als Indiz für das Lebensdauerende wenigstens eines Kontaktstückes (1, 11, 2, 3, 41, 51, 61) herangezogen wird, **dadurch gekennzeichnet**, daß zwischen den Kontaktstücken (1; 11, 21, 31; 41, 51, 61) und dem zugehörigen Kontaktträger (2; 12, 22, 32) oder im Kontaktmaterial selbst die elektrische Signalleitung (4, 8, 100, 300) U-förmig geführt ist,

2. Schaltgerät nach Anspruch 1, **dadurch gekennzeichnet**, daß die U-förmig geführte Signalleitung durch eine Schleife (8a, 9a) mit zwei gegeneinander isolierten Zuleitungen (8, 9) gebildet ist.

3. Schaltgerät nach Anspruch 2, **dadurch gekennzeichnet**, daß die U-förmige Schleife (8a, 9a) in einer metallummantelten Röhre (7) gegeneinander isoliert geführt ist.

4. Schaltgerät nach einem der Ansprüche 3, **dadurch gekennzeichnet**, daß die U-förmige Schleife (8a, 9a) in der metallummantelten Röhre (7) als erdfreies Mantelthermoelement realisiert ist.

5. Schaltgerät nach Anspruch 3, **dadurch gekennzeichnet**, daß die eine Zuleitung (8) der U-förmigen Schleife (8, 9) über einen Vorwiderstand (6) an den Nulleiter oder eine der beiden Phasen des zu schaltenden Netzes gelegt ist und die andere Zuleitung (9) über ein Anzeigemittel (5) an den Kontaktträger (2) zurückgeführt ist.

6. Schaltgerät nach Anspruch 1, **dadurch gekennzeichnet**, daß das Kontaktstück (1) an der rückseitigen Lotfläche eine Nut (3a) aufweist, in der zumindest ein isolierter elektrischer Leiter (300, 3, 4) der U-förmig geführten Leitung verläuft.

7. Schaltgerät nach Anspruch 6, **dadurch gekennzeichnet**, daß die Isolation (3) des elektrischen Leiters (4) aus einer Glasfaserummantelung oder aus einer anderen temperaturbeständigen Isolation besteht.

8. Schaltgerät nach Anspruch 1, zur Schaltung eines Netzes mit mehreren Phasen und einem Nulleiter, **dadurch gekennzeichnet**, daß der elektrische Leiter (4) über ein Anzeigemittel (5) und zugehörigem Vorwiderstand (6) mit dem Nulleiter oder einer weiteren Phase des zu schaltenden Netzes verbunden ist.

9. Schaltgerät nach Anspruch 1, **dadurch gekennzeichnet**, daß die U-förmig geführte Signalleitung über die gesamte Rückseite des Kontaktstückes (1) verläuft und daß das eine Ende (4a) des Leiters (4) über einen Widerstand (6) an den Nulleiter oder die anderen Phasen des zu schaltenden Netzes und das andere Ende (4b) des Leiters (4) über ein Anzeigemittel (5) an den Kontaktträger (2) angeschlossen ist.

10. Schaltgerät nach Anspruch 1, **dadurch gekennzeichnet**, daß der feste Kontaktträger (2; 12, 22, 32) zur Anzeige herangezogen wird.

11. Schaltgerät nach Anspruch 6, **dadurch gekennzeichnet**, daß die Höhe (4) der Nut (3a) ein Maß zur Definition einer frei wählbaren Restlebensdauer der Kontaktstücke (1; 11, 21, 31) ist.

## Claims

1. Switching device, in particular a contactor or circuit breaker, having contact points (1; 11, 21, 31; 41, 51, 61) which are fastened in a switching-device housing on contact carriers (2; 12, 22, 32), and having an electrically insulated signal line (4, 100, 300) as means for monitoring the contact erosion, whereby damage to or destruction of the signal line (4, 100, 300) is used to generate an external signal as a sign of the end of the service life of at least one contact point (1, 11, 2, 3, 41, 51, 61), characterized in that between the contact points (1; 11, 21, 31; 41, 51, 61) and the associated contact carrier (2; 12, 22, 32) or in the contact material itself the electrical signal line (4, 8, 100, 300) is guided in a U-shape.

2. Switching device according to claim 1, characterized in that the signal line which is guided in a U-shape is formed by a loop (8a, 9a) with two supply lines (8, 9) which are insulated against each other.

3. Switching device according to claim 2, characterized in that the U-shaped loop (8a, 9a) is guided in a metal-encased tube (7), insulated against each other.

4. Switching device according to claim 3, characterized in that the U-shaped loop (8a, 9a) in the metal-encased tube (7) is realized as a non-earthed sheathed thermocouple.

5. Switching device according to claim 3, characterized in that the one supply line (8) of the U-shaped loop (8, 9) is applied by way of a series resistance (6) to the zero conductor or one of the two phases of the network to be connected and the other supply line (9) is returned to the contact carrier (2) by way of display means (5).

6. Switching device according to claim 1, characterized in that the contact point (1) has a groove (3a) at the rear soldering surface, in which groove at least one insulated electric conductor (300, 3, 4) of the line guided in a U-shape extends.

7. Switching device according to claim 6, characterized in that the insulation (3) of the electric conductor (4) consists of a fibre-glass casing or of another heat-resistant insulation.

8. Switching device according to claim 1, for the connection of a network with several phases and a zero conductor, characterized in that the electric conductor (4) is connected by way of display means (5) and associated series resistance (6) to the zero conductor or another phase of the network to be connected.

9. Switching device according to claim 1, characterized in that the signal line guided in a U-shape extends over the entire rear side of the contact point (1) and in that the one end (4a) of the conductor (4) is connected by way of a resistance (6) to the zero conductor or the other phases of the network to be connected and the other end (4b) of the conductor (4) is connected by way of display means (5) to the contact carrier (2).

10. Switching device according to claim 1, characterized in that the secure contact carrier (2; 12, 22, 32) is used for the display.

11. Switching device according to claim 6, characterized in that the height (4) of the groove (3a) is a measure for the definition of a freely selectable residual service life of the contact points (1; 11, 21, 31).

## Revendications

1. Appareil de coupure, notamment fusible ou disjoncteur, comportant des pièces (1; 11, 21, 31; 41, 51, 61) de contact, qui sont fixées dans un boîtier d'appareil de coupure sur des supports (2; 12, 22, 32) de contact, et comportant une ligne (4, 100, 300) de signalisation isolée électriquement, servant de moyen de surveillance de l'usure des contacts, un endommagement ou une destruction de la ligne (4, 100, 300) de signalisation étant utilisé pour produire un signal externe comme indication de la fin de la durée de vie d'au moins une pièce (1, 11, 2, 3, 41, 51, 61) de contact, caractérisé en ce que la ligne (4, 8, 100, 300) de signalisation électrique passe en forme de U entre les pièces (1; 11, 21, 31; 41, 51, 61) de contact et le support (2; 12, 22, 32) de contact associé ou dans le matériau de contact lui-même.

2. Appareil de coupure suivant la revendication 1, caractérisé en ce que la ligne de signalisation guidée en forme de U est formée par une boucle (8a, 9a) comportant deux lignes (8, 9) d'alimentation isolées l'une de l'autre.

3. Appareil de coupure suivant la revendication 2, caractérisé en ce que la boucle (8a, 9a) en forme de U est guidée dans un tube (7) gainé de métal en en étant isolé.

4. Appareil de coupure suivant l'une des revendications 1 à 3, caractérisé en ce que la boucle (8a, 9a) en forme de U située dans le tube (7) gainé de métal est réalisée en thermocouple gainé isolé de la terre.

5. Appareil de coupure suivant la revendication 3, caractérisé en ce que l'une des lignes (8) d'alimentation de la boucle (8, 9) en forme de U est raccordée par l'intermédiaire d'une résistance (6) série au conducteur neutre ou à l'une des deux phases du réseau d'alimentation et l'autre ligne (9) d'alimentation est renvoyée au support (2) de contact par l'intermédiaire d'un moyen (5) d'indication.

6. Appareil de coupure suivant la revendication 1, caractérisé en ce que la pièce (1) de contact comporte sur la face arrière de brasage une rainure (3a) dans laquelle passe au moins un conducteur (300, 3, 4) électrique isolé de la ligne guidée en forme de U.

7. Appareil de coupure suivant la revendication 6, caractérisé en ce que l'isolant (3) du conducteur (4) électrique est constitué d'une gaine de fibres de verre ou d'un autre isolant résistant à la température.

8. Appareil de coupure suivant la revendication 1, destiné à être connecté à un réseau comportant plusieurs phases et un conducteur neutre, caractérisé en ce que le conducteur (4) électrique est relié, par l'intermédiaire d'un moyen (5) d'indication et d'une résistance (6) série associée, au conducteur neutre ou à une autre phase du réseau d'alimentation.

9. Appareil de coupure suivant la revendication 1, caractérisé en ce que la ligne de signalisation guidée en forme U s'étend sur toute la face arrière de la pièce (1) de contact et en ce qu'une extrémité (4a) du conducteur (4) est raccordée au conducteur neutre ou aux autres phases du réseau à couper par l'intermédiaire d'une résistance (6) et l'autre extrémité (4b) du conducteur (4) est raccordée au support (2) de contact par l'intermédiaire d'un moyen (5) d'indication.

10. Appareil de coupure suivant la revendication 1, caractérisé en ce que le support (2; 12, 22, 32) de contact fixe est utilisé pour l'indication.

11. Appareil de coupure suivant la revendication 6, caractérisé en ce que la hauteur (h) de la rainure (3a) est une mesure servant à définir une durée de vie restante, pouvant être choisie librement, des pièces (1; 11, 21, 31) de contact.
